# EUROPÄISCHE PATENTSCHRIFT

(11) **EP 0 912 002 B1**
(45) Veröffentlichungstag und Bekanntmachung des Hinweises auf die Patenterteilung: **29.11.2006**
(21) Anmeldenummer: 98116758.8
(22) Anmeldetag: 04.09.1998
(51) Int. Cl.: H04H 1/00

(54) **Verfahren zur Speicherung von Daten von Rundfunksendefrequenzen in einem Datenspeicher eines Rundfunkempfängers**
Method for storing broadcast transmission frequency data in a memory of a broadcast receiver
Méthode pour stocker des données de fréquences d'émission dans une mémoire d'un récepteur de radiodiffusion

(30) Priorität: 24.10.1997 DE 19746960
(43) Veröffentlichungstag der Anmeldung: 28.04.1999
(73) Patentinhaber: ROBERT BOSCH GMBH, 70442 Stuttgart (DE)
(72) Erfinder: Hegeler, Wilhelm, 31134 Hildesheim (DE)

(56) Entgegenhaltungen:
- EP-A- 0 305 172
- EP-A- 0 364 749
- WO-A-97/15998

## Beschreibung

### Stand der Technik

Die Erfindung geht von einem Verfahren zur Speicherung von Daten von Rundfunksendefrequenzen in einem Datenspeicher eines Rundfunkempfängers, insbesondere eines Autoradios, nach der Gattung des Hauptanspruchs aus.

Gemäß der "Specifications of the radio data System RDS for VHF/FM sound broadcasting" der European Broadcasting Union vom März 1984 werden über Sendefrequenzen von Rundfunksendern neben den eigentlichen Hörfunkprogrammen auch digitale Daten wie Programmkettenkennungen (PI) ausgestrahlt, die angeben, welches Programm über eine empfangene Sendefrequenz ausgestrahlt wird. Außerdem werden im Rahmen des Radio-Daten-Systems auch sogenannte Alternativ-Frequenz-(AF)-Listen übertragen, die Informationen über alternative Sendefrequenzen enthalten, über die dasselbe Programm übertragen wird, wie über eine aktuell empfangene Sendefrequenz. Aufgrund dieser Informationen wird ein Rundfunkempfänger in die Lage versetzt, bei sich verschlechterndem Empfang, dies ist besonders bei Rundfunkempfängern mit veränderlichem Standort, also beispielsweise Autoradios von Bedeutung, gegebenenfalls unter gleichzeitiger Auswertung der Programmkettenkennung automatisch auf eine alternative Sendefrequenz gleichen Programminhalts mit besseren Empfangseigenschaften umzuschalten.

Es sind Rundfunkempfänger vorgeschlagen worden, die über Speicher zum Ablegen von über das Radio-Daten-System übertragenen Informationen über alternative Frequenzen und die den alternativen Frequenzen zugeordneten Programmkettenkennungen verfügen. So wird beispielsweise in DE 196 26 253 ein Verfahren zur Speicherung der Daten einer empfangenen Trägerfrequenz eines Rundfunksenders in einem Datenspeicher eines Rundfunkempfängers beschrieben, bei dem aus der mit der empfangenen Sendefrequenz übertragenen Programmkettenkennung die Sendebereichskennung, auch als Regionalkennung bezeichnet, die die Verbreitung des Programms anzeigt, abgetrennt und der verbleibende Hauptteil der Programmkettenkennung, sodann die abgetrennte Regionalkennung und schließlich die empfangene Sendefrequenz jeweils zwischen den nach aufsteigenden Werten geordneten abgespeicherten Daten anderer Trägerfrequenzen in den Datenspeicher eingeschrieben werden. Darüberhinaus wird jeder im Datenspeicher abgelegten Sendefrequenz eine ihre Empfangsqualität anzeigende Kennung zugeordnet.

Ein mit einem solchen Datenspeicher für Sendefrequenzen ausgestatteter Rundfunkempfänger ist somit in der Lage, beispielsweise im Falle einer Empfangsverschlechterung einer empfangenen Sendefrequenz unter Rückgriff auf die im Datenspeicher abgelegten Informationen auch dann, wenn aktuell z. B. in Folge der Empfangsverschlechterung kein Datensignal empfangen werden kann, schnell auf eine alternative Frequenz gleichen Programminhalts umzuschalten, sofern eine solche verfügbar ist.

Im WO-A-9715998 wird ein anderes Verfahren zur Speicherung von Daten in einem Datenspeicher eines Rundfunkempfängers offenbart.

Schließlich ist aus der genannten RDS-Spezifikation, wie aus der RDS-TMC-Spezifikation ENV 12313-1, CEN TC 278 vom November 1996 bekannt, daß mittels speziell dafür vorgesehener Gruppentypen - beim Radio-Daten-System sind zur Übertragung verschiedenartiger Informationsarten verschiedene Gruppentypen vorgesehen - im Rahmen des sogenannten traffic message chanal (TMC) digital kodierte Verkehrsinformationen wie beispielsweise Staumeldungen übertragen werden, die nach ihrer Dekodierung im Rundfunkempfänger in synthetische Sprache umgesetzt und auf Wunsch des Bedieners wiedergegeben werden.

Aufgrund der Tatsache, daß TMC-Daten innerhalb des RDS-Signals vergleichsweise selten, nämlich mit einer Wiederholrate in der Größenordnung von Sekunden übertragen werden, gestaltet sich die Suche nach einer alternativen Sendefrequenz, über die TMC-Daten übertragen werden, und die darüber hinaus noch über dieselbe Programmkettenkennung verfügt wie die aktuell empfangene Sendefrequenz im Rahmen eines Sendersuchlaufs als zeitaufwendig und damit für den Benutzer inakzeptabel, da während der Suchdauer keine Sendefrequenz mit befriedigenden Empfangseigenschaften zum Empfang zur Verfügung steht.

### Vorteile der Erfindung

Das erfindungsgemäße Verfahren mit den Merkmalen des Hauptanspruchs ermöglicht die Ausbildung eines Rundfunkempfängers zum Empfang von beispielsweise mittels des Radio-Daten-Systems übertragenen digital kodierten Verkehrsinformationen dergestalt, daß durch Speicherung und entsprechende Kennzeichnung von Alternativfrequenzen, über die TMC-Daten übertragen werden, beispielsweise im Falle eines sich verschlechternden Empfangs einer aktuell empfangenen Sendefrequenz aufgrund der gespeicherten Daten schnell eine nach dem TMC-Standard Informationen übertragende Alternativfrequenz verfügbar ist, so daß eine zeitaufwendige Alternativfrequenz-Suche entfallen kann. Darüberhinaus ermöglicht die Zuordnung der Kennung zu der Regionalkennung für den Fall, daß alle unter der Regionalkennung bzw. der Programmkettenkennung gespeicherten Sendefrequenzen TMC-Daten nach einem vorgegebenen Standard übertragen, eine besonders speicherplatzsparende Kennzeichnung der TMC-Informationen übertragenden Alternativfrequenzen.

Eine Kennzeichnung einzelner Sendefrequenzen ist demnach nur dann erforderlich, wenn über verschiedene Sendefrequenzen unter der gleichen Programmkettenkennung keine TMC-Daten oder TMC-Daten nach einem von einem vorgegebenen Standard abweichenden Standard übertragen werden.

Gemäß einer Weiterbildung des erfindungsgemäßen Verfahrens ist es dabei vorgesehen, zur Kennzeichnung weitere Informationen ausstrahlender Sendefrequenzen die mittels des Radio-Daten-Systems übertragene sogenannte location table number (LTN) zu verwenden, die anzeigt, nach welchem Standard TMC-Informationen kodiert bzw. übertragen werden. Auf diese weise kann die Kennzeichnung der Sendefrequenzen auch dann beibehalten werden, wenn der zum Empfang vorgegebene Standard für TMC-Meldungen beispielsweise durch den Benutzer geändert wird, da aufgrund der gespeicherten LTN nach Änderung des Standards eine Überprüfung der Alternativfrequenzen auf Übereinstimmung mit dem neuen vorgegebenen Standard jederzeit möglich ist. Somit stehen nach Änderung des vorgegebenen Standards zur Übertragung weiterer Informationen sofort markierte Sendefrequenzen, sofern überhaupt verfügbar, zur Verfügung.

Eine andere Weiterbildung des erfindungsgemäßen Verfahrens, bei der die den Sendefrequenzen zugeordneten Kennungen aus der location table number abgeleitet sind und beispielsweise nur 1 Bit zur Kennzeichnung, ob oder ob nicht weitere Informationen nach einem vorgegebenen Standard übertragen werden, ermöglicht eine weitere Verringerung des Speicherplatzbedarfs bei der Kennzeichnung der Sendefrequenzen.

Weiterhin ist es von Vorteil, den Inhalt des Datenspeichers durch zeitweilige Überprüfung der Sendefrequenzen darauf, ob über sie tatsächlich weitere Informationen nach dem vorgegebenen Standard übertragen werden, auf dem aktuellen Stand zu halten, so daß im Falle eines Empfangsfrequenzwechsels auf eine gespeicherte Alternativfrequenz beispielsweise in Folge sich verschlechternder Empfangsverhältnisse zuverlässig davon ausgegangen werden kann, daß über die gewählte Alternativfrequenz auch tatsächlich weitere Informationen übertragen werden. Damit kann im Falle einer Umschaltung der Sendefrequenz auf eine Alternativfrequenz eine zu diesem Zeitpunkt störende weil zeitaufwendige Prüfung unterbleiben.

Eine Weiterbildung der Erfindung, bei der sämtliche zu einem PI-Hauptteil verfügbaren Sendefrequenzen in einer seperaten Liste gespeichert und hinsichtlich ihrer TMC-Relevanz markiert werden, ermöglicht auf einfache Weise die Verwendung von Sendefrequenzen verwandter Regionalprogramme derselben Programmkette als Alternativfrequenzen für zum Beispiel eine empfangsqualitätbedingte Umschaltung von einer aktuellen auf eine alternative Sendefrequenz.

### Zeichnungen

Ausführungsbeispiele der Erfindung sind in den Zeichnungen dargestellt und werden im folgenden näher erläutert.

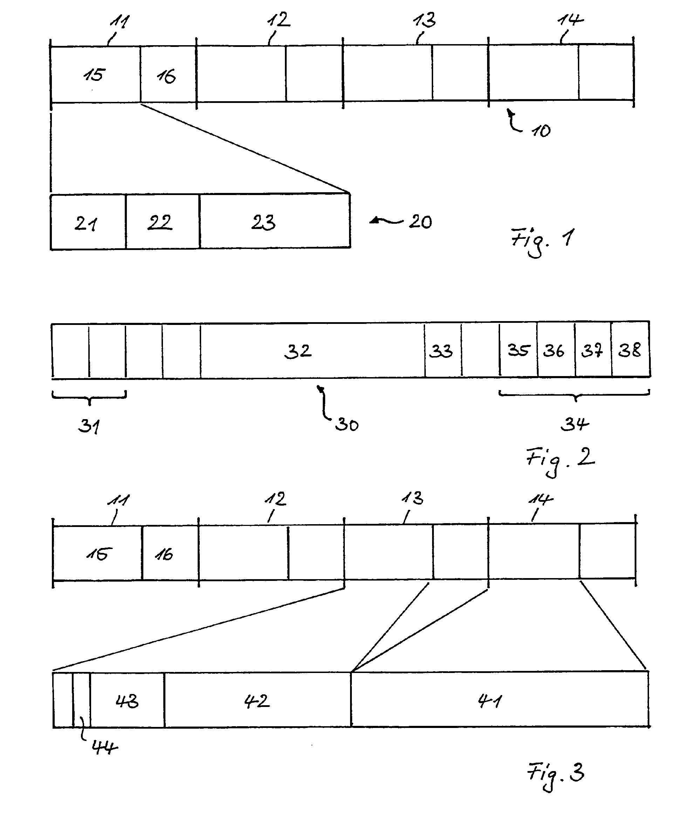

Es zeigen Figur 1 schematisch den Aufbau des gemäß der eingangs erwähnten RDS-Spezifikation im ersten als Block A bezeichneten Block einer jeden RDS-Gruppe übertragenen Programmkettenkennung (PI),
Figur 2 schematisch den Aufbau einer ersten Variante des Gruppentyps 3a, in dem zum Auffinden von TMC-Informationen ausstrahlenden Rundfunksendefrequenzen erforderliche Informationen übertragen werden,
Figur 3 den Aufbau einer ersten Variante des Gruppentyps 8a zur Übertragung der eigentlichen TMC-Verkehrsinformationen,
Figur 4 einen Rundfunkempfänger zur Durchführung des erfindungsgemäßen Verfahrens und
Figur 5 beispielhaft den Inhalt eines Datenspeichers eines Rundfunkempfängers zur Durchführung des erfindunggemäßen Verfahrens.

### Beschreibung eines Ausführungsbeispiels

Figur 1 zeigt schematisch den Aufbau einer einzelnen Gruppe 10 des Radio-Daten-Signals, das sich aus einer Hintereinanderreihung einer Vielzahl von Gruppen unterschiedlicher Typen, wobei verschiedenartige Gruppentypen zur Übertragung verschiedener Informationsarten vorgesehen sind, zusammensetzt. Jede Gruppe des RDS-Signals setzt sich dabei aus vier sogenannten Blöcken 11, 12, 13 und 14, die auch als Blöcke A bis D bezeichnet werden, zu je 16 Bit zusammen. Jeder Block umfaßt dabei einen Informationsteil 15, in dem die eigentlich zu übertragenden Informationen enthalten sind, und einen 10 Bit langen Abschnitt 16, der sich aus einem aus dem Dateninhalt des Informationswort 15 berechneten Kontrollwort und einem diesem überlagerten Offsetword zur Kennzeichnung der Nummer des Blocks zusammensetzt.

Gemäß der eingangs erwähnten spezifikation des Radio-Daten-Systems enthält der erste Block (Block A) einer jeden Gruppe des Radio-Daten-Signals eine sogannte Programmkettenkennung (Program Identification) 20, über die das über die Sendefrequenz übertragene Programm eindeutig identifizierbar ist. Die Programmkettenkennung 20 setzt sich dabei aus einer Länderkennung 21, die anzeigt, in welchem Land das Programm ausgestrahlt wird, einer Senderbereichskennung 22, auch als Regionalkennung bezeichnet, die die Verbreitung des über die Sendefrequenz ausgestrahlten Programms angibt und einer Programmbezugszahl 23, auch als Programmkennung bezeichnet, die in verschlüsselter Form den Bezug zum ausgestrahlten Programm herstellt, zusammen. Ein Beispiel für eine solche Programmkettenkennung ist beispielsweise der Wert D382 für das Programm NDR2 des Norddeutschen Rundfunks, wobei D der Länderkennung 21 entspricht und im vorliegenden Fall für die Bundesrepublik Deutschland steht, die Ziffer 3 die Regionalkennung 22 darstellt und im vorstehenden Fall eine Supraregionale Verbreitung, also die Ausstrahlung des Programms in großen Teilen des Landes anzeigt und die letzten beiden Ziffern 8 und 2 der Senderbezugszahl 23 entsprechen, die im vorliegenden Fall das zweite Programm des Norddeutschen Rundfunks bezeichnet. Im Zusammenhang mit der vorliegenden Erfindung wird der Teil der Programmkettenkennung 20, der sich durch Weglassen der Regionalkennung 22 ergibt, und somit nur noch aus der Länderkennung 21 und der Programmkennung 23 besteht, auch als Hauptteil der Programmkettenkennung bezeichnet.

Figur 2 zeigt schematisch den Informationsteil 30 des Blocks C einer ersten Variante des Gruppentyps 3a gemäß der vorerwähnten RDS-TMC-Spezifikation. Dieser enthält u. a. einen die ersten beiden Bits umfassenden Variantencode 31, der im Falle der ersten Variante den Wert 00 aufweist, sodann die 6 Bit umfassende location table number (LTN) 32, die angibt, nach welchem Standard die mittels des Radio-Daten-Systems über die ausgestrahlte Sendefrequenz übertragenen Verkehrsinformationen kodiert werden, weiterhin einen alternative frequency indicator (AFI) 33, kurz als AFI-Bit bezeichnet, das anzeigt, ob die gemäß der RDS-Specification in der Gruppe 0A übertragenen Listen alternativer Frequenzen zu der aktuell empfangenen Sendefrequenz, die den gleichen Programminhalt und somit die gleiche Programmkettenkennung wie die aktuell empfangene Sendefrequenz aufweisen, auch weitere Informationen in Form der TMC-Verkehrsinformationen nach einem vorgegebenen Standard übertragen. Dabei wird das AFI-Bit auf den Wert 1 gesetzt, wenn die in der Gruppe 0A übertragenen Sendefrequenzen auch für TMC gültig sind, das heißt, wenn über alle Sendefrequenzen der in der Gruppe 0A übertragenen AF-Liste die weiteren Informationen nach dem vorgegebenen Standard übertragen werden. Dagegen müssen im Falle AFI = 0 die Informationen über alternative Sendefrequenzen, über die weitere Informationen nach dem vorgegebenen Standard übertragen werden, aus anderen Quellen, wie beispielsweise aus Tuning-Informationen aus der zweiten Variante der RDS-Gruppe 8A gewonnen werden. Schließlich enthält der Informationsteil des Blockes 10 der Gruppe 3a in ihrer ersten Variante noch ein die letzten vier Bits 35 bis 38 umfassendes sogenanntes message geographical scope (MGS) 34, das ähnlich wie die Regionalkennung der Programmkettenkennung 20 die Verbreitung bzw. die Bedeutung der über die Sendefrequenz mittels des TMC-Systems ausgestrahlten Verkehrsinformationen für verschiedene Regionen anzeigt.

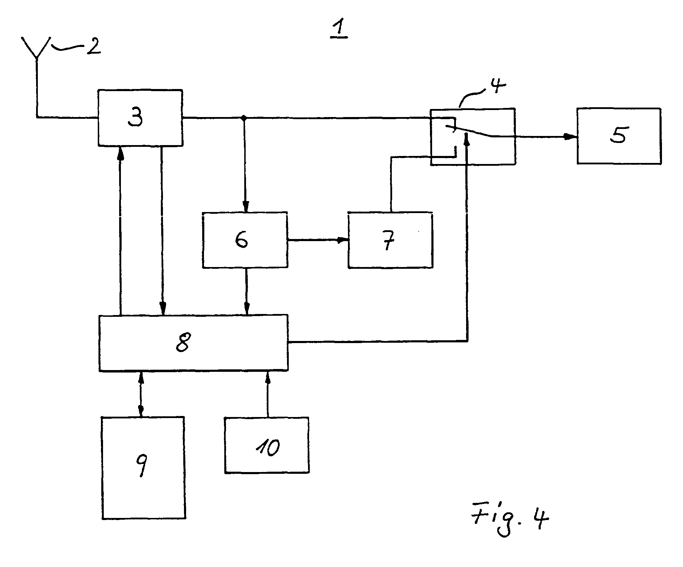

In Figur 3 ist schließlich schematisch der Aufbau einer einzelnen, nach dem TMC-System übertragenen Verkehrsinformation, die im wesentlichen die Dateninhalte der Blöcke C und D einer ersten Variante der Gruppe 8a des Radio-Daten-Signals umfaßt, dargestellt. Die Verkehrsinformation 40 setzt sich dabei aus einem ersten Teil 41 zusammen, der den Ort eines Ereignisses kennzeichnet. Der Ortscode 41 umfaßt dabei den kompletten Datenteil des Blockes D der Gruppe 3a. Weiterhin enthält die Verkehrsmeldung 40 einen 10 Bit umfassenden Teil 42, in dem das zu meldende Ereignis, beispielsweise ein Stau oder zähfließender Verkehr, näher spezifiziert ist. In einem Teil 43 der Verkehrsmeldung 49, der weitere 4 Bit umfaßt, wird die Ausdehnung des Ereignisses beschrieben. Schließlich ist noch ein Richtungsbit 44 vorgesehen, daß in Verbindung mit dem Ortscode 41 die genaue Lokalisation des Ereignisses ermöglicht.

In einem Rundfunkempfänger zum Empfang von nach RDS-TMC-System übertragenen Verkehrsinformationen ist es nun vorgesehen, diese in geeigneter Weise zu entschlüsseln, in synthetische Sprache umzuwandeln und die solchermaßen für einen Benutzer verständlich gemachte Verkehrsinformation auf dessen Wunsch akustisch wiederzugeben.

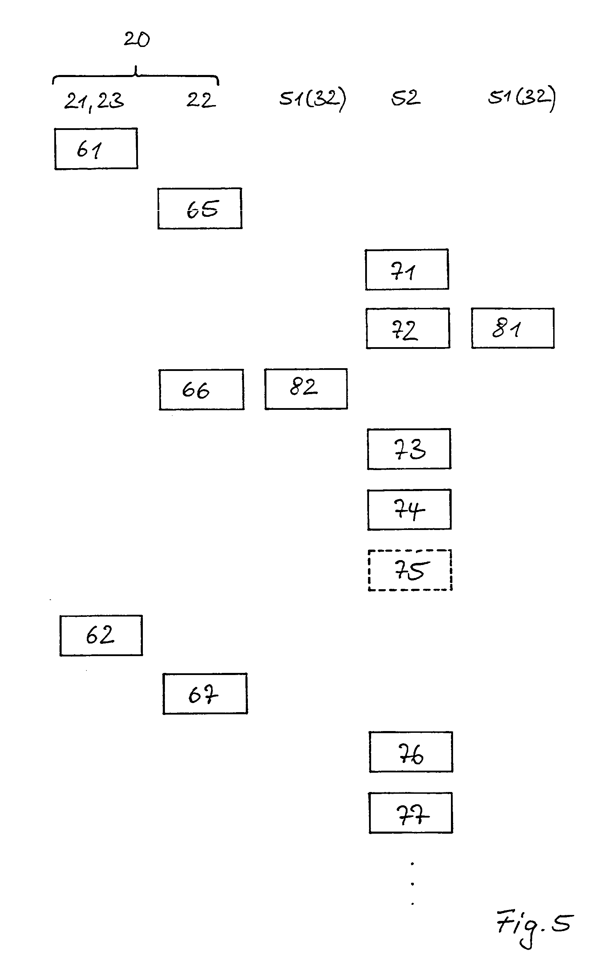

Ein solcher Rundfunkempfänger zum Empfang von nach dem RDS-TMC-System übertragenen Verkehrssinformationen und zur akustischen Wiedergabe derselben, indem auch das erfindungsgemäße Verfahren zur Speicherung von Daten von Rundfunksendefrequenzen implementiert ist, ist in Figur 4 dargestellt.

Das an einer Empfangsantenne 2 des Rundfunkempfängers 1 anstehende Rundfunksignal ist einer Empfangseinheit 3 zugeführt, die über die zum Empfang und zur Demodulation des Empfangssignals erforderlichen Mittel wie eine Mischstufe zur Trennung einer gewünschten Trägerfrequenz von den übrigen an der Empfangsantenne 2 anstehenden Trägerfrequenzen und zur Herabmischung derselben in ein Zwischenfrequenzsignal, eine ZF-Stufe zur Verstärkung des zwischenfrequenten Signals, einen Demodulator zur Gewinnung des der Trägerfrequenz aufmodulierten Programm- und Datensignals sowie eine Schaltung zur Bewertung der Empfangsqualität der mittels der Mischstufe ausgewählten Sendefrequenz enthält. Das am Ausgang der Empfangseinheit 3 abgreifbare Stereo-Multiplexsignal (MPX) ist einem ersten Eingangskontakt eines Schalters 4 zugeführt, dessen Ausgang einer Wiedergabeeinheit 5, die über die zur Wiedergabe des zugeführten Stereo-Multiplexsignals erforderlichen Mittel, wie einen Stereodekoder, Niederfrequenzverstärker und Lautsprecher verfügt, zugeführt. Weiterhin ist der Ausgang des Empfangteils 3 mit dem Eingang eines RDS-Dekoders 6 zur Demodulation und Auswertung des dem im Stereo-Multiplexsignal enthaltenen 57 kHz Hilfsträger aufmodulierten RDS-Signals verbunden. Ein erster Ausgang des RDS-Dekoders 6 ist mit einer Schaltungseinheit 7 zur Auswertung der mittels des RDS-TMC-Systems über die empfangene Sendefrequenz übertragenen weiteren Informationen und zur Umsetzung derselben in synthetische Sprache verbunden. Der Ausgang der Schaltungseinheit 7, an dem die nun in Form synthetischer Sprache vorliegenden Verkehrsinformationen anstehen, ist einem zweiten Kontakt des Schalters 4 zugeführt und damit bei Ansteuerung des Schalters 4 der Wiedergabeeinheit 5 zur akustischen Wiedergabe zuführbar. Der zweite Ausgang des RDS-Dekoders 6, an dem Abstimmhilfsinformationen, wie beispielsweise die Programmkettenkennung, Listen alternativer Frequenzen, die im Rahmen der Gruppe 3a übertragene location table number und das AFI-Bit abnehmbar sind, ist einer Steuerung 8 des Rundfunkempfängers 1 zugeführt. Ebenso ist der Steuerung 8 das Ausgangssignal der die Empfangsqualität einer empfangenen Sendefrequenz bewertenden Schaltung zugeführt. Außerdem steht die Steuerung 8 mit einer Bedieneinheit 10 und einem Datenspeicher 9 zur Speicherung von Daten von Rundfunksendefrequenzen in Verbindung.

Die Funktionsweise des in Figur 4 dargestellten Rundfunkempfängers 1 zur Durchführung des erfindungsgemäßen Verfahrens wird nun in Verbindung mit dem in Figur 5 beispielhaft dargestellten Speicherinhalt des Datenspeichers 9 des Rundfunkempfängers 1 beschrieben.

Auf die Betätigung beispielsweise einer Senderwahltaste an der Bedieneinheit 10 stimmt die Steuereinheit 8 des Rundfunkempfängers 1 die Abstimmeinheit bzw. die Mischstufe der Empfangseinheit 3 zum Empfang einer Sendefrequenz ab. Das über die empfangene Sendefrequenz übertragene Rundfunkprogramm, das in dem am Ausgang der Empfangseinheit 3 abnehmbaren MPX-Signal enthalten ist, wird über den Schalter 4 der Wiedergabeeinheit 5 zugeleitet und über die Lautsprecher der Wiedergabeeinheit 5 akustisch wiedergegeben. Für den Fall, daß über die empfangene Sendefrequenz RDS-Signale übertragen werden, werden diese in dem RDS-Dekodor demoduliert und der Steuerung 8, und, sofern sie auch nach dem TMC-Signal übertragene Verkehrsinformationen enthalten, der Schaltungseinheit 7 zugeführt. Die über das RDS/TMC-Signal empfangenen, wie in Figur 3 dargestellt, digital kodierten Verkehrsinformationen werden in der Schaltungseinheit 7 ausgewertet und in synthetische Sprache umgewandelt. Durch Betätigung einer entsprechenden Verkehrsfunkwiedergabetaste an der Bedieneinheit 10 steuert die Steuerung 8 den Schalter 4 an, worauf der Ausgang der Schaltungseinheit 7 mit der Wiedergabeeinheit 5 verbunden wird, so daß die durch die Schaltungseinheit 7 zur Verfügung gestellten in akustischer Form vorliegenden Verkehrsfunkinformationen über die Wiedergabeeinheit 5 wiedergegeben werden.

In der Steuerung 8 werden die u. a. aus dem RDS-Signal der empfangenen Sendefrequenz gewonnenen Daten der aktuell empfangenen und gegebenenfalls weiterer Sendefrequenzen ausgewertet, und damit die im Datenspeicher 9 des Rundfunkempfängers abgelegten Daten von Rundfunksendefrequenzen aktualisiert und gegebenenfalls ergänzt. So wird nach Einstellung einer neuen Empfangsfrequenz an der Abstimmeinheit bzw. der Mischstufe des Empfangsteils 3 über die Steuerung 8 das über die neu eingestellte Sendefrequenz übertragene Radio-Daten-Signal in dem RDS-Dekoder 6 demoduliert und zur weiteren Auswertung der Steuerung 8 zugeführt. Dort wird von der Programmkettenkennung 20 die Regionalkennung 22 abgetrennt, der verbleibende Hauptteil des PI-Codes 21, 23 mit den bereits im Datenspeicher 9 nach aufsteigenden Werten gespeicherten PI-Code-Hauptteilen 21, 23 verglichen, bei erfolgreichem Vergleich die Regionalkennung 22 mit den bereits innerhalb des den PI-Codes zugeordneten Datenblöcken nach aufsteigenden Werten geordnet gespeicherten Regionalkennungen 22 verglichen, bei Erfolg dieses Vergleichs die empfangene Trägerfrequenz selbst mit den innerhalb des der Regionalkennung zugeordneten Frequenzblöcken bereits nach aufsteigenden Werten geordnet gespeicherten Trägerfrequenzen verglichen, im Erfolgsfall des Vergleichs die vermeintlich neue Sendefrequenz verworfen, da diese bereits im Datenspeicher abgelegt ist und bei Fehlen eines Erfolges des Vergleichs die Trägerfrequenz bzw. die Regionalkennung bzw. der Hauptteil des PI-Codes an der Stelle gespeichert, die dem Wert der Trägerfrequenz bzw. der Regionalkennung bzw. dem Hauptteil des PI-Codes entspricht. Bei Fehlen eines leeren Speicherplatzes an der durch den Wert der Empfangsfrequenz bzw. der Regionalkennung bzw. des Hauptteils des PI-Codes vorgegebenen Stelle im Datenspeicher 9 werden die zuvor gespeicherten Daten in Richtung leerer Speicherplätze verschoben und, falls solche nicht vorhanden sind, gegebenenfalls andere Daten gelöscht.

Diese Verfahrensweise soll im folgenden am Beispiel der am Rundfunkempfänger neu eingestellten Sendefrequenz 75 verdeutlicht werden. Im Datenspeicher 9 sind aktuell die PI-Hauptteile 61 und 62, unter dem PI-Hauptteil 61 die Regionalkennungen 65 und 66, unter dem PI-Hauptteil 62 die Regionalkennung 67, unter der Regionalkennung 65 die Sendefrequenzen 71 und 72, unter der Regionalkennung 66 die Sendefrequenzen 73 und 74 und unter der Regionalkennung 67 die Sendefrequenzen 76 und 77 gespeichert. Nach Einstellung der neuen Sendefrequenz 75 am Empfangsteil 3 sind am Ausgang des RDS-Dekoders 6 die mittels des Radio-Daten-Systems über die Sendefrequenz 75 übertragenen RDS-Daten abnehmbar. In der Steuerung 8 wird nun die Regionalkennung 32 aus dem der Sendefrequenz 75 zugeordneten PI-Code 61, 66 herausgelöst, der verbleibende Hauptteil 61 des PI-Codes sodann mit den im Datenspeicher 9 abgelegten Hauptteilen 61, 62 verglichen. Aufgrund der festgestellten Übereinstimmung des Hauptteils des PI-Codes 61 der neu empfangen Sendefrequenz 75 mit dem bereits im Datenspeicher abgelegten Hauptteil 61 wird daraufhin die aus dem PI-Code herausgelöste Regionalkennung 66 mit dem unter dem Hauptteil 61 bereits im Datenspeicher abgelegten Regionalkennungen 65 und 66 verglichen. Aufgrund der Übereinstimmung der Regionalkennung der empfangenen Sendefrequenz mit der bereits im Datenspeicher abgelegten Regionalkennung 66 wird anschließend die neu empfangene Sendefrequenz 75 selbst mit den unter dem PI-Code 61, 66 gespeicherten Sendefrequenzen 73 und 74 verglichen. Da keine Übereinstimmung der Sendefrequenzen festgestellt wird, wird die neue Sendefrequenz 75 an der aufgrund ihrer Höhe zukommenden Stelle im Datenspeicher, im vorliegenden Fall hinter den Sendefrequenzen 73 und 74 abgelegt.

Weiterhin wird aufgrund der mittels des Radio-Daten-Signals übertragenen Informationen festgestellt, ob es sich bei der neu im Datenspeicher abgelegten Sendefrequenz um eine Sendefrequenz handelt, über die auch digital kodierte Verkehrsinformationen nach dem RDS-TMC-Standard übertragen werden und ob diese Informationen nach einem vorgegebenen Standard übertragen werden. Ist dies der Fall, so wird die neu im Speicher 9 abgelegte Sendefrequenz 75 mit einer entsprechenden Kennung versehen. Für den Fall, daß über alle Sendefrequenzen, die unter der gleichen Programmkettenkennung 61, 66 wie die neu gespeicherte Sendefrequenz 75 abgelegt sind, die weiteren Informationen in Form der Verkehrsinformationen nach dem RDS-TMC-Standard übertragen werden, dazu diese weiteren Informationen bei allen Sendefrequenzen unter der selben Programmkettenkennung nach dem gleichem Standard kodiert werden, wird die weitere Kennung 82 zur Kennzeichnung der TMC-Sendefrequenz der Programmkettenkennung 61, 66 zugeordnet und im vorliegenden Fall unmittelbar hinter der entsprechenden Regionalkennung 66 im Speicher abgelegt. Für den Fall, daß wie im Beispiel anhand der Sendefrequenzen 71 und 72 dargestellt, über verschiedene derselben Programmkettenkennung 61, 65 zugeordnete Sendefrequenzen keine weiteren oder weitere Informationen nach von dem vorgegebenen Standard abweichenden Standards übertragen werden, wird nur der unter der Programmkettenkennung bzw. Regionalkennung 61, 65 abgelegten Sendefrequenz 42, über die weitere Informationen nach dem vorgegebenen Standard übertragen werden, die weitere Kennung zugeordnet.

Alternativ kann es im letztgenannten Fall jedoch auch vorgesehen sein, nicht nur TMC-Informationen nach dem vorgegebenen Standard übertragende Sendefrequenzen zu kennzeichnen, sondern jeder Sendefrequenz ein solches Kennzeichen zuzuordnen, das anzeigt, ob oder ob nicht weitere Informationen nach dem vorgegebenen Standard übertragen werden.

Beim vorliegenden Ausführungsbeispiel ist es dabei vorgesehen, daß die weitere Kennung der mittels des Radio-Daten-Systems über die empfangene Sendefrequenz übertragenen location table number (LTN) entspricht. Dies ermöglicht eine Beibehaltung der im Datenspeicher abgelegten Frequenzdaten auch dann, wenn der vorgegebene Standard zur Übertragung von weiteren Informationen beispielsweise durch den Benutzer gewechselt wird.

So ist es beispielsweise vorstellbar, daß in Zukunft verschiedene Diensteanbieter TMC-Verkehrsfunkinformationen nach unterschiedlichen Standards übertragen. In diesem Falle ist es vorstellbar, daß der Empfang von TMC-Meldungen erst nach Erwerb einer Zugangsberechtigung beim Diensteanbieter ermöglicht wird. So wäre es beispielsweise denkbar, daß erst nach Erwerb einer entsprechenden Chipkarte die Auswahl eines TMC-Standards, und somit überhaupt erst der Empfang von TMC-Meldungen an bzw. über einen Rundfunkempfänger ermöglicht wird.

Ebenso ist es aber auch denkbar, daß beispielsweise TMC-Meldungen in verschiedenen Ländern nach verschiedenen Standards übertragen werden. Besonders in diesem Fall ist es von Interesse möglichst schnell nach Wechsel von einem ersten in ein zweites Empfangsgebiet Frequenzdaten zur Verfügung zu haben, die einen schnellen Wechsel auf eine TMC-Sendefrequenz ermöglichen, so daß hier die Speicherung der vollständigen LTN als weiteres Kennzeichen bei Wechsel des Standards eine schnelle Aussage darüber ermöglicht, ob über die durch sie gekennzeichnete Sendefrequenz TMC nach dem vorgegebenen Standard übertragen wird.

Bei einem weiteren Ausführungsbeispiel des erfindungsgemäßen Verfahrens ist es vorgesehen, daß statt der location table number als Kennung die im Datenspeicher abgelegten Sendefrequenzen mittels einer aus der lacation table number abgeleiteten Kennung markiert werden. Im einfachsten Falle kann diese abgeleitete Kennung aus einem einzelnen Bite bestehen, das anzeigt ob oder ob nicht über die betroffene Sendefrequenz weitere Informationen nach dem vorgegebenen Standard übertragen werden.

Weiterhin kommt der Steuerung 8 des Rundfunkempfängers 1 zur Durchführung des erfindungsgemäßen Verfahrens die Aufgabe zu, die im Datenspeicher 9 abgelegten Daten von Rundfunksendefrequenzen in regelmäßigen Zeitabständen zu überprüfen und gegebenenfalls zu aktualisieren. So ist es bei einem Ausführungsbeispiel des erfindungsgemäßen Verfahrens vorgesehen, daß dann, wenn die Information darüber, ob über die einer Programmkettenkennung zugeordneten Sendefrequenzen weitere Informationen nach dem vorgegebenen Standard übertragen werden, innerhalb einer vorgegebenen Zeitdauer in den über die empfangene Sendefrequenz übertragenen Informationen nicht erkannt wird, die der Programmkettenkennung und/oder den Sendefrequenzen zugeordnete weitere Kennung gelöscht wird, da dann nicht mehr zuverlässig davon ausgegangen werden kann, daß über die vormals gekennzeichneten Sendefrequenzen tatsächlich noch TMC nach dem vorgegebenen Standard übertragen wird. Ebenso ist es vorgesehen, daß für den Fall, daß sich die mittels des RDS-Signals der empfangenen Sendefrequenz übertragenen location table number ändert auch die entsprechenden Einträge im Datenspeicher angepaßt werden.

Beim vorliegenden Ausführungsbeispiel ist es vorgesehen, daß die Information darüber, ob über eine empfangene Sendefrequenz weitere Informationen übertragen werden, aus dem in der Gruppe 3a des Radiodatensignals übertragenen AFI-Bit abgeleitet werden. So wird dem Rundfunkempfänger zur Durchführung des erfindungsgemäßen Verfahrens dann, wenn alle Sender mit einer bestimmten Programmkettenkennung weitere Informationen in Form von TMC-Meldungen mit derselben Datenbasis senden, mit der Information AFI = 1 ermöglicht, zur Ermittlung alternativer Sendefrequenzen, über die das gleiche Programm und außerdem TMC-Meldungen nach dem gleichen Standard übertragen werden, aus der mittels des Radio-Daten-Signals ausgestrahlten Liste alternativer Frequenzen (Gruppe 0A) zu verwenden. Weiterhin ist es im Fall AFI = 1 möglich, die location table number oder die aus ihr abgeleitete Kennung direkt einer kompletten Programmkettenkennung, das heißt, im vorliegenden Fall einer Regionalkennung im Datenspeicher zuzuordnen. Für den Fall, daß AFI = 0 und somit nicht alle Sender mit einem bestimmten PI TMC mit derselben Datenbasis senden, wird mit der Information AFI = 0 dem Gerät mitgeteilt, daß die über das Radio-Daten-Signal übertragene AF-Liste für TMC-Alternativfrequenzen nicht gültig ist. In diesem Falle müssen gültige Alternativfrequenzen beispielsweise den in der Gruppe 8a in der zweiten Variante übertragenen Tuninginformationen entnommen werden. Außerdem muß bei AFI = 0 die Information, ob über eine Sendefrequenz weitere Informationen nach dem vorgegebenen Standard übertragen werden, jeder betroffenen Alternativfrequenz zugeordnet werden. Da da Eintragen der LTN bei jeder Alternativfrequenz sehr speicherintensiv wäre, wird in diesem Falle beim vorliegenden Ausführungsbeispiel jeder Alternativfrequenz, die als TMC-Alternativfrequenz in Frage kommt, jeweils nur 1 Bit zugeordnet.

Bei einem weiteren Ausführungsbeispiel des erfindungsgemäßen Verfahrens ist es vorgesehen, daß eine Liste zumindest der unter dem Hauptteil der Programmkettenkennung der aktuell empfangenen Frequenz verfügbaren Regionalkennungen angelegt wird, in der diejenigen Regionalkennungen markiert werden, über deren zugeordnete Sendefrequenzen weitere Informationen nach dem vorgegebenen Standard übertragen werden. Beim vorliegenden Ausführungsbeispiel ist es dabei vorgesehen, daß zu der Liste der unter dem Hauptteil der Programmkettenkennung der aktuell empfangenen Sendefrequenz verfügbaren Regionalkennungen ein Datenwort angelegt wird, das soviele binäre Stellen umfaßt, wie in der Liste Regionalkennungen enthalten sind, und daß die Regionalkennungen, über deren zugeordnete Sendefrequenzen weitere Informationen nach dem vorgegebenen Standard übertragen werden, durch Setzen der Bits in dem Datenwort, deren Nummer der Position der Regionalkennung in der Liste entspricht, markiert werden.

Aufgrund der im Datenspeicher abgelegten Informationen und/oder einer beispielsweise in einem zusätzlichen Arbeitsspeicher eines Rundfunkempfängers abgelegten Liste von unter dem Hauptteil der Programmkettenkennung der aktuell empfangenen Sendefrequenz verfügbaren Regionalkennungen ist der Rundfunkempfänger 1 zur Durchführung des erfindungsgemäßen Verfahrens nunmehr in der Lage, bei sich verschlechternden Empfangsbedienungen der aktuell empfangenen Sendefrequenz, die der Steuerung von der Bewertungsschaltung im Empfangsteil 3 mitgeteilt wird, automatisch auf eine alternative Sendefrequenz, die über bessere Empfangseigenschaften verfügt, über die das gleiche Programm und darüber hinaus TMC-Daten nach dem gleichen Standard übertragen werden, umzuschalten. In einem alternativen, als "Reg-Off" bezeichneten Betriebszustand, in dem bei der Auswahl einer Alternativfrequenz aus dem Datenspeicher die Regionalkennung des PI nicht berücksichtigt wird, stehen dem erfindungsgemäßen Rundfunkempfänger zur Umschaltung auf eine Alternativfrequenz auch die unter demselben Hauptteil der Programmkettenkennung abgelegten Sendefrequenzen als alternative Sendefrequenzen zur Verfügung, das heißt, es werden auch solche Sendefrequenzen zugelassen, über die nicht das identische Programm, sondern ein regional verwandtes Programm, das sich nur in seiner Regionalkennung von dem ursprünglich empfangenen Programm unterscheidet.

## Patentansprüche

1. Verfahren zur Speicherung von Daten von Rundfunksendefrequenzen in einem Datenspeicher eines Rundfunkempfängers, insbesondere eines Autoradios, wobei Programmkettenkennungen (PI) und dazu gehörige Sendefrequenzen gespeichert werden,
wobei die Programmkettenkennungen die über die Sendefrequenzen übertragenen Programme identifizieren,
wobei weitere Kennungen im Speicher ablegbar sind,
**dadurch gekennzeichnet,**
**daß** die weiteren Kennungen anzeigen, ob über die Sendefrequenzen weitere Informationen übertragen werden und ob diese Informationen nach einem vorgegebenen Standard übertragen werden, und daß für den Fall, daß über alle einer bestimmten Programmkettenkennung (PI) zugeordneten Sendefrequenzen die weiteren Informationen nach dem vorgegebenen Standard übertragen werden, die weitere Kennung der Programmkettenkennung (PI) zugeordnet wird.

2. Verfahren nach Anspruch 1, **dadurch gekennzeichnet, daß** von der Programmkettenkennung die Regionalkennung, die die räumliche Verbreitung des durch die Programmkettenkennung bezeichneten Rundfunkprogramms anzeigt, abgetrennt wird,
daß unter den verbleibenden Hauptteilen einer jeden Programmkettenkennung die dazu verfügbaren Regionalkennungen und unter den Regionalkennungen die dazu verfügbaren Sendefrequenzen abgespeichert werden, und daß dann, wenn über alle einer bestimmten Programmkettenkennung (PI) zugeordneten Sendefrequenzen die weiteren Informationen nach dem vorgegebenen Standard übertragen werden, die weitere Kennung der Regionalkennung der Programmkettenkennung (PI) zugeordnet wird.

3. Verfahren nach Anspruch 1 oder 2, **dadurch gekennzeichnet, daß** für den Fall, daß über verschiedene derselben Programmkettenkennung (PI) zugeordnete Sendefrequenzen keine weiteren oder weitere Informationen nach von dem vorgegebenen Standard abweichenden Standards übertragen werden, jeder unter der Programmkettenkennung (PI) bzw. Regionalkennung abgelegten Sendefrequenz die weitere Kennung zugeordnet wird.

4. Verfahren nach einem der Ansprüche 1 bis 3, **dadurch gekennzeichnet, daß** die weiteren über die Sendefrequenzen übertragenen Informationen digital codierte, vorzugsweise mittels des Radio-Daten-Systems (RDS) übertragene Verkehrsfunkinformationen oder/und Warnmeldungen sind.

5. Verfahren nach einem der Ansprüche 1 bis 4, **dadurch gekennzeichnet, daß** die Information darüber, ob über die einer Programmkettenkennung zugeordneten Sendefrequenzen oder über einzelne Sendefrequenzen weitere Informationen nach dem vorgegebenen Standard übertragen werden, aus über eine empfangene Sendefrequenz, vorzugsweise mittels des Radio-Daten-Systems übertragenen Informationen gewonnen wird.

6. Verfahren nach Anspruch 5, **dadurch gekennzeichnet, daß** die weitere Kennung der mittels des Radio-Daten-Systems über die empfangene Sendefrequenz übertragenen Location-Table-Number (LTN) entspricht oder aus dieser abgeleitet ist.

7. Verfahren nach Anspruch 5 oder 6, **dadurch gekennzeichnet, daß** dann, wenn die Information darüber, ob über die einer Programmkettenkennung zugeordneten Sendefrequenzen weitere Informationen nach dem vorgegebenen Standard übertragen werden, innerhalb einer vorgegebenen Zeitdauer in den über die empfangene Sendefrequenz übertragenen Informationen nicht erkannt wird, die der Programmkettenkennung und/oder den Sendefrequenzen zugeordnete weitere Kennung gelöscht wird.

8. Verfahren nach einem der vorhergehenden Ansprüche, **dadurch gekennzeichnet, daß** eine Liste zumindest der unter dem Hauptteil der Programmkettenkennung der aktuell empfangenen Frequenz verfügbaren Regionalkennungen angelegt wird, in der diejenigen Regionalkennungen markiert werden, über deren zugeordnete Sendefrequenzen weitere Informationen nach dem vorgegebenen Standard übertragen werden.

9. Verfahren nach Anspruch 8, **dadurch gekennzeichnet, daß** zu der Liste der unter dem Hauptteil der Programmkettenkennung der aktuell empfangenen Sendefrequenz verfügbaren Regionalkennungen ein Datenwort angelegt wird, das so viele binäre Stellen umfaßt, wie in der Liste Regionalkennungen enthalten sind, und daß die Regionalkennungen, über deren zugeordnete Sendefrequenzen weitere Informationen nach dem vorgegebenen Standard übertragen werden, durch Setzen der Bits in dem Datenwort, deren Nummer der Position der Regionalkennungen in der Liste entspricht, markiert werden.

## Claims

1. Method for storing broadcast transmission frequency data in a memory of a broadcast receiver, in particular a car radio, whereby programme identifications (PI) and associated transmission frequencies are stored,
whereby the programme identifications identify the programmes transmitted via the transmission frequencies,
whereby further identifications can be stored in the memory,
**characterized in that**
the further identifications indicate whether further information is transmitted via the transmission frequencies, and whether this information is transmitted according to a predefined standard, and, in the event that the further information is transmitted according to the predefined standard via all transmission frequencies assigned to a specific programme identification (PI), the further identification is assigned to the programme identification (PI).

2. Method according to Claim 1, **characterized in that** the regional identification which indicates the geographical distribution of the broadcast programme designated by the programme identification is separated from the programme identification, the relevant available regional identifications are stored under the remaining main parts of each programme identification and the relevant available transmission frequencies are stored under the regional identifications, and, if the further information is transmitted according to the predefined standard via all transmission frequencies assigned to a specific programme identification (PI), the further identification is assigned to the regional identification of the programme identification (PI).

3. Method according to Claim 1 or 2, **characterized in that**, if no further information or further information according to standards other than the predefined standard is transmitted, the further identification is assigned to each transmission frequency stored under the programme identification (PI) or regional identification.

4. Method according to one of Claims 1 to 3, **characterized in that** the further information transmitted via the transmission frequencies is digitally coded traffic radio information and/or warning messages, preferably transmitted by means of the Radio Data System (RDS).

5. Method according to one of Claims 1 to 4, **characterized in that** the information indicating whether further information is transmitted according to the predefined standard via the transmission frequencies assigned to a programme identification or via individual transmission frequencies is obtained from information transmitted via a received transmission frequency, preferably by means of the Radio Data System.

6. Method according to Claim 5, **characterized in that** the further identification corresponds to the Location Table Number (LTN) transmitted by means of the Radio Data System via the received transmission frequency, or is derived therefrom.

7. Method according to Claim 5 or 6, **characterized in that**, if the information indicating whether further information is transmitted according to the predefined standard via the transmission frequencies assigned to a programme identification is not recognised within a predefined time period in the information transmitted via the received transmission frequency, the further identification assigned to the programme identification and/or the transmission frequencies is deleted.

8. Method according to one of the preceding claims, **characterized in that** a list of at least the regional identifications available under the main part of the programme identification of the currently received frequency is compiled, in which the regional identifications are marked via whose assigned transmission frequencies further information is transmitted according to the predefined standard.

9. Method according to Claim 8, **characterized in that** a data word is created for the list of regional frequencies available under the main part of the programme identification of the currently received transmission frequency, said data word comprising as many binary digits as are contained in the list of regional identifications, and the regional identifications via whose assigned transmission frequencies further information is transmitted according to the predefined standard are marked by setting the bits in the data word, the number of which corresponds to the position of the regional identifications in the list.

## Revendications

1. Procédé de mémorisation de données de fréquences d'émission de radiodiffusion dans une mémoire d'un récepteur radio, en particulier d'un autoradio, selon lequel on mémorise des indicatifs de chaînes de programmes (PI) et des fréquences d'émission associées, les indicatifs de chaînes de programmes identifiant les programmes transmis sur les fréquences d'émission, et d'autres indicatifs peuvent être enregistrés dans la mémoire,
**caractérisé en ce que**
les autres indicatifs indiquent si d'autres informations sont transmises sur les fréquences d'émission et si ces informations sont transmises selon une norme prédéterminée, et
dans le cas où les autres informations sont transmises conformément à la norme prédéterminée sur toutes les fréquences d'émission associées à un indicatif de chaîne de programme (PI) défini, l'autre indicatif est associé à l'indicatif de chaîne de programme (PI).

2. Procédé selon la revendication 1,
**caractérisé en ce que**
l'indicatif régional, qui indique la diffusion spatiale du programme de radiodiffusion désigné par l'indicatif de chaîne de programme, est séparé de l'indicatif de chaîne de programme,
les indicatifs régionaux disponibles parmi les parties principales restantes dans chaque indicatif de chaîne de programme, et les fréquences d'émission disponibles parmi les indicatifs régionaux sont mémorisé(e)s, puis
lorsque les autres informations conformément à la norme prédéterminée sont transmises sur toutes les fréquences d'émission associées à un indicatif de chaîne de programme (PI) défini, l'autre indicatif est associé à l'indicatif régional de l'indicatif de chaîne de programme (PI).

3. Procédé selon la revendication 1 ou 2,
**caractérisé en ce que**
dans le cas où aucune autre information conforme à des normes différentes de la norme prédéterminée n'est transmise sur différentes fréquences d'émission associées au même indicatif de chaîne de programme (PI), l'autre indicatif est associé à chaque fréquence d'émission enregistrée sous l'indicatif de chaîne de programme (PI) ou l'indicatif régional.

4. Procédé selon une des revendications 1 à 3,
**caractérisé en ce que**
les autres informations transmises sur les fréquences d'émission sont des informations de radioguidage et/ou des messages d'avertissements codé(e)s numériquement et de préférence transmis(e)s au moyen du système de radiocommunication de données (RDS).

5. Procédé selon une des revendications 1 à 4,
**caractérisé en ce que**
l'information relative au fait que d'autres informations sont transmises conformément à la norme prédéterminée sur les fréquences d'émission associées à un indicatif de chaîne de programme ou sur des fréquences d'émission particulières, est obtenue à partir d'informations transmises sur une fréquence d'émission reçue, de préférence au moyen du système de radiocommunication de données.

6. Procédé selon la revendication 5,
**caractérisé en ce que**
l'autre indicatif correspond au numéro de table de situation (LTN : location table number) transmis au moyen du système de radiocommunication de données sur la fréquence d'émission reçue ou est dérivée de celui-ci.

7. Procédé selon la revendication 5 ou 6,
**caractérisé en ce que**
lorsque l'information relative au fait que d'autres informations sont transmises conformément à la norme prédéterminée sur les fréquences d'émission associées à un indicatif de chaîne de programme, n'est pas détectée dans les informations transmises sur la fréquence d'émission reçue pendant une durée prédéterminée, l'autre indicatif associé à l'indicatif de chaîne de programme et/ou aux fréquences d'émission est effacé.

8. Procédé selon l'une des revendications précédentes,
**caractérisé en ce qu'**
on crée une liste comportant au moins les indicatifs régionaux disponibles sous la partie principale de l'indicatif de chaîne de programme de la fréquence actuelle reçue, et dans celle-ci on marque les indicatifs régionaux où d'autres informations sont transmises conformément à la norme prédéterminée sur leurs fréquences d'émission associées.

9. Procédé selon la revendication 8,
**caractérisé en ce qu'**
on crée dans la liste des indicatifs régionaux disponibles sous la partie principale de l'indicatif de chaîne de programme de la fréquence d'émission actuellement reçue, un mot de données qui comprend autant de positions binaires que d'indicatifs régionaux sont contenus dans la liste, et
les indicatifs régionaux pour lesquels d'autres informations sont transmises conformément à la norme prédéterminée sur leurs fréquences d'émission associées, sont marquées par un positionnement des bits dans le mot de données dont le numéro correspond à la position des indicatifs régionaux dans la liste.
